# FASCICULE DE BREVET EUROPEEN

(11) **EP 3 537 593 B1**
(45) Date de publication et mention de la délivrance du brevet: **24.04.2024**
(21) Numéro de dépôt: 18160980.1
(22) Date de dépôt: 09.03.2018
(51) Int. Cl.: H02N 2/02, H02N 2/04, G04B 11/02, G04C 3/12

(54) **DISPOSITIF DE ROTATION D'UNE ROUE DENTÉE**
ROTATIONSVORRICHTUNG FÜR EIN ZAHNRAD
DEVICE FOR ROTATING A TOOTHED WHEEL

(43) Date de publication de la demande: 11.09.2019
(73) Titulaire: ETA SA Manufacture Horlogère Suisse, 2540 Grenchen (CH)
(72) Inventeur: Lagorgette, Pascal, 2502 Bienne (CH); Meyer, Pascal, 2000 Neuchâtel (CH)
(74) Mandataire: ICB SA

(56) Documents cités:
- EP-A1- 2 735 923
- FR-A5- 2 034 030
- US-A- 3 297 889
- US-A- 3 509 714
- US-A1- 2007 029 197
- US-A1- 2007 164 635
- US-A1- 2016 181 951

## Description

### Domaine de l'invention

L'invention se rapporte au domaine technique des dispositifs de rotation de roues dentées au moyen de moteurs piézoélectriques linéaires.

### Arrière-plan de l'invention

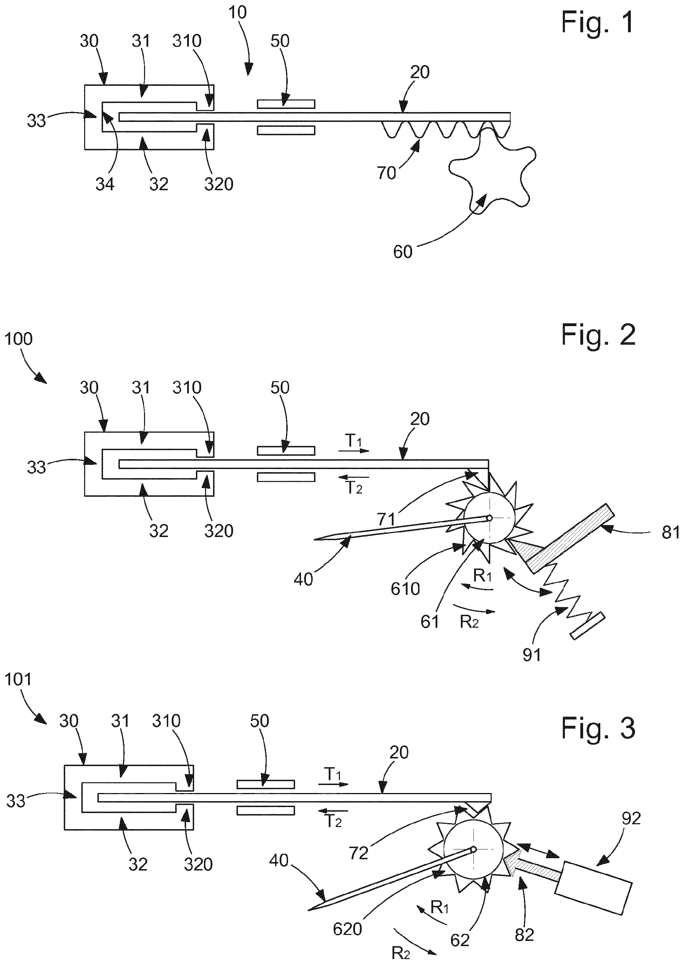

Un moteur piézoélectrique linéaire comporte classiquement un élément passif et un actionneur permettant de déplacer linéairement l'élément passif en utilisant l'effet piézoélectrique. En référence à la figure 1, on connait en particulier les moteurs piézoélectriques 10 linéaires pour lesquels l'élément passif est un élément allongé 20 (par exemple une barre à section rectangulaire) et l'actionneur piézoélectrique comporte un résonateur 30 formé d'une paire de bras 31, 32 connectés l'un à l'autre au niveau d'une zone de connexion 33, sensiblement en forme de diapason ou de U. L'actionneur comporte en outre deux éléments piézoélectriques (non représentés), chacun attaché à l'un des bras 31, 32, et jouant le rôle de moyens d'excitation des bras pour leur imposer des vibrations. D'autre part, l'élément passif 20 s'étend sensiblement parallèlement aux bras 31, 32 du résonateur 30, son guidage axial étant assuré par des moyens de guidage 50 se trouvant à distance du résonateur. L'élément passif 20 est également en contact local avec les extrémités libres 310, 320 des bras 31, 32 du résonateur 30, de sorte que l'élément passif 20 soit déplacé axialement par friction des extrémités libres 310, 320 des bras 31, 32 sur la région de contact.

Dans des applications où il est important de réduire l'encombrement du moteur piézoélectrique, en particulier dans le domaine horloger, les bras 31, 32 du résonateur 30 doivent être de faible longueur, ce qui limite la course linéaire maximale de l'élément passif 20. La translation axiale de l'élément passif 20 dans le sens de la zone de connexion 33 est limitée par la présence de ladite zone de connexion 33 qui fait office de butée, et son déplacement axial dans l'autre sens est limitée par la longueur des bras 31, 32. Cette course limitée est problématique dans certaines situations, notamment si l'élément passif 20 engrène avec une roue 60, par exemple par l'intermédiaire d'un système à crémaillère 70, car la rotation de la roue 60 est alors restreinte. A titre d'exemple, si la course de l'élément passif 20 est limitée à environ 1 millimètre, alors le diamètre de la roue 60 doit être au maximum d'environ 0.3 millimètre pour que ladite roue 60 puisse effectuer un tour complet lors de la course. Cette dimension est trop faible pour être réalisable techniquement.

Chacun des documents US 2007/029197A1 (voir Fig. 5), US 3509714A (voir Fig. 2), ainsi que US 3297889A (voir Fig. 4) divulgue un dispositif de rotation d'une roue dentée comprenant un moteur piézoélectrique linéaire, avec les caractéristiques du préambule de la revendication 1.

### Résumé de l'invention

Le but de la présente invention est de permettre une rotation complète de la roue sans augmenter la course linéaire maximale de l'élément passif.

A cet effet, l'invention se rapporte à un dispositif de rotation d'une roue dentée, comprenant :
- un moteur piézoélectrique linéaire comprenant :
   - un élément passif de forme allongée,
   - un actionneur piézoélectrique apte à déplacer axialement l'élément passif de manière bidirectionnelle,
- un organe de transmission solidaire fixé à l'élément passif, adapté pour être en prise avec une denture de la roue de sorte à faire tourner la roue d'une dent selon un premier sens de rotation lorsque l'élément passif est déplacé axialement selon un premier sens de déplacement,
- un sautoir mobile entre deux positions extrémales dont une position abaissée dans laquelle il bloque une rotation de la roue dans un deuxième sens de rotation opposé au premier sens de rotation.

A chaque déplacement linéaire de l'élément passif dans le premier sens de déplacement réalisé grâce à l'actionneur piézoélectrique, la roue tourne d'une dent dans le premier sens de rotation grâce à l'organe de transmission. A chaque déplacement linéaire de l'élément passif dans un deuxième sens de déplacement opposé au premier réalisé grâce à l'actionneur piézoélectrique, la roue reste immobile grâce au sautoir abaissé. La roue peut donc effectuer un tour complet dans le premier sens de rotation par des mouvements répétés de va et vient de l'élément passif.

Selon l'invention :
- l'organe de transmission est adapté pour être en prise avec la denture de la roue de sorte à faire tourner la roue d'une dent dans le deuxième sens de rotation lorsque l'élément passif est déplacé axialement selon un deuxième sens de déplacement opposé au premier sens de déplacement,
- le sautoir, dans sa position abaissée, est adapté à bloquer une rotation de la roue dans le premier sens de rotation.

Ceci est avantageux car il permet, au choix, de faire tourner la roue dans le premier sens de rotation ou alors dans le deuxième sens de rotation. La roue ne peut toutefois pas être à rochet : en effet, l'organe de transmission doit être capable de faire tourner la roue d'une dent dans le deuxième sens de rotation lorsque le sautoir n'est pas en position abaissée et que l'élément passif est déplacé dans le deuxième sens de déplacement. A chaque déplacement axial de l'élément passif dans le deuxième sens de déplacement réalisé grâce à l'actionneur piézoélectrique, la roue tourne d'une dent dans le deuxième sens de rotation grâce à l'organe de transmission. A chaque déplacement linéaire de l'élément passif dans le premier sens de déplacement grâce à l'actionneur piézoélectrique, la roue reste immobile grâce au sautoir abaissé. La roue peut donc effectuer un tour complet dans le deuxième sens de rotation par des mouvements répétés de va et vient de l'élément passif.

Dans un mode particulier de réalisation, le dispositif de rotation comporte des moyens d'actionnement permettant de basculer le sautoir d'une position extrémale à l'autre. Les moyens d'actionnement comprennent par exemple un deuxième actionneur piézoélectrique linéaire permettant d'approcher et d'éloigner le sautoir de la roue.

La position du sautoir est ainsi contrôlée de manière indépendante : la roue ne peut pas déloger le sautoir de la position abaissée comme dans le premier mode de réalisation.

Dans un mode de réalisation non limitatif, l'actionneur piézoélectrique comporte un résonateur comprenant une paire de bras connectés à l'une de leurs extrémités au niveau d'une zone de connexion, les deux autres extrémités étant dites libres, l'élément passif passant entre les extrémités libres desdits bras de sorte à être déplacé axialement par friction des extrémités libres sur sa surface.

Un tel actionneur est de faible encombrement, notamment de faible épaisseur, et est facile à fabriquer et à assembler.

Dans un mode de réalisation, le dispositif de rotation comprend des moyens de guidage axial de l'élément passif tendant à ramener l'élément passif dans sa position initiale lorsque l'élément passif en est dévié sous l'effet d'un déplacement axial de l'élément passif combiné à un blocage en rotation de la roue.

En effet, lorsque l'élément passif se réarme, c'est-à-dire revient dans sa position initiale après avoir fait tourner la roue d'une dent, il peut se soulever sous l'effet d'un contact entre l'organe de transmission et la prochaine dent que l'organe de transmission devra pousser pour faire tourner à nouveau tourner la roue. Les moyens de guidage permettent d'éviter que l'élément passif ne se désaxe, en le ramenant dans son alignement initial.

Selon un autre aspect, l'invention concerne une pièce d'horlogerie comportant une roue et ledit dispositif de rotation.

Dans un mode de réalisation, la pièce d'horlogerie comporte une aiguille solidaire en rotation de la roue.

### Description sommaire des dessins

D'autres particularités et avantages ressortiront clairement de la description qui en est faite ci-après, à titre indicatif et nullement limitatif, en référence aux dessins annexés, dans lesquels :
- la figure 1, déjà décrite, représente schématiquement un dispositif de rotation selon l'art antérieur,
- la figure 2 représente schématiquement un dispositif de rotation selon un exemple ne faisant pas partie de l'invention,
- la figure 3 représente schématiquement un dispositif de rotation selon un mode de réalisation de l'invention,
- la figure 4 représente schématiquement un diagramme fonctionnel des étapes d'un procédé de rotation d'une roue comme représentée à la Fig. 2.

### Description détaillée des modes de réalisation préférés

La figure 2 montre un dispositif de rotation 100 d'une roue 61 selon un exemple ne faisant pas partie de l'invention, et la figure 3 montre un dispositif de rotation 101 d'une roue 62 selon un mode de réalisation de l'invention. Dans les deux cas, le dispositif de rotation 100, 101 comporte un moteur piézoélectrique. Le moteur piézoélectrique comprend un élément passif 20 de forme allongée, et un actionneur piézoélectrique permettant de mettre en translation (c'est-à-dire déplacer linéairement/axialement) l'élément passif 20 en utilisant l'effet piézoélectrique.

Dans le mode de réalisation illustré, l'actionneur piézoélectrique des moyens d'excitation piézoélectrique, non représentés, et un résonateur 30 comprenant deux bras 31, 32 aptes à osciller. Les moyens d'excitation sont avantageusement constitués de deux parties, chacune attachée à un bras différent. Toutefois, d'autres modes de réalisation des moyens d'excitation sont possibles, ils peuvent par exemple être constitués d'une seule partie disposés au niveau d'une jointure entre les bras. Lors de l'application d'une tension adaptée aux moyens d'excitation, les moyens d'excitation se déforment, et des contraintes mécaniques sont transmises aux bras 31, 32 qui se mettent alors à osciller. Par une conception et un montage appropriés des moyens d'excitation sur les bras, des oscillations multidimensionnelles de forme souhaitée peuvent être réalisées.

Les bras 31, 32 sont connectés au niveau d'une zone de connexion 33, et s'étendent sensiblement parallèlement l'un à l'autre depuis ladite zone de connexion 33. Le résonateur 30 a donc globalement une forme de diapason, c'est-à-dire une forme de U. Toutefois, cette forme n'est pas limitative. Les extrémités des bras non connectées à la zone de connexion 33, sont dites extrémités libres 310, 320. L'amplitude des oscillations des bras 31, 32 est maximale à ces extrémités 310, 320.

L'élément passif 20 s'étend sensiblement parallèlement aux bras 31, 32 et passe entre les extrémités libres 310, 320 desdits bras 31, 32. Ainsi, le résonateur 30 encadre une première zone extrémale de l'élément passif 20. Les oscillations multidimensionnelles des extrémités libres 310, 320 des bras 31, 32 permettent d'imposer une translation axiale à l'élément passif 20, par frottement desdites extrémités 310, 320 contre l'élément passif 20. On comprend que la translation dans le sens de la zone de connexion 33 est limitée par ladite zone de connexion 33, et que la translation dans l'autre sens est limitée par la longueur des bras 31, 32.

On note que l'actionneur piézoélectrique pourrait tout à fait être d'un autre type que celui précédemment décrit, l'important étant qu'il est apte à translater axialement l'élément passif 20 dans un sens de déplacement comme dans l'autre.

Le dispositif de rotation 100, 101 comporte également des moyens de guidage 50 axial de l'élément passif 20, permettant de maintenir son orientation lors de sa translation. Les moyens de guidage 50 sont placés à distance de l'actionneur piézoélectrique. Il s'agit par exemple d'un rail.

Le dispositif de rotation comporte également un organe de transmission 71, 72 et un sautoir 81, 82. L'organe de transmission 71, 72 et le sautoir 81, 82 comportent un cran dont la forme est avantageusement adaptée à la denture de la roue. L'organe de transmission 71, 72 est fixé à une deuxième zone extrémale de l'élément passif 20, opposée par rapport à la première zone extrémale. L'organe de transmission 71, 72 est disposé par rapport à la roue de sorte à pouvoir faire tourner la roue dans au moins un sens de rotation lorsque l'élément passif 20 est translaté dans un sens de déplacement sous l'action de l'actionneur piézoélectrique. Le sautoir 81, 82 est mobile entre deux positions extrémales. Dans une de ces positions, dite position abaissée, le sautoir 81, 82 est calé entre deux dents de la roue 61, 62.

Dans l'exemple illustré à la figure 2, la roue 61 est une roue à rochet, destinée à ne tourner que dans un premier sens de rotation R1. Une rotation dans le premier sens de rotation R1 n'est possible par l'intermédiaire de l'organe de transmission 71 que lorsque l'élément passif 20 est translaté dans un premier sens de déplacement T1 : l'organe de transmission 71 vient en contact puis pousse un des rochets 610 de la roue 61, faisant tourner la roue 61 d'une dent.

Dans cet exemple, le dispositif de rotation 100 comporte des moyens de rappel 91 se présentant sous la forme d'un élément élastique, par exemple un ressort ou une lame, tendant à pousser le sautoir 81 contre les rochets de la roue. Lorsque la roue 61 tourne dans le premier sens de rotation R1, le sautoir 81 est soulevé sous le passage d'une dent, et ramené en position abaissée sous l'effet des moyens de rappel 91, de sorte à suivre sensiblement la forme de la denture. Naturellement, lorsque le sautoir est en position abaissée, la roue à rochet 61 ne peut pas tourner dans un deuxième sens de rotation R2 opposé au premier sens de rotation R1.

Ainsi, lors d'une translation de l'élément passif 20 dans le sens de déplacement T1, la roue à rochet 61 tourne d'une dent, et lors d'une translation de l'élément passif 20 dans un sens de déplacement T2 opposé au sens de déplacement T1, la roue à rochet 61 est immobilisée par le sautoir 81. En effectuant une pluralité d'allers et retours de l'élément passif 20, il est possible de faire tourner la roue 61 dans le premier sens de rotation R1 d'une pluralité de dents. Une course maximale faible de l'élément passif 20 suffit donc.

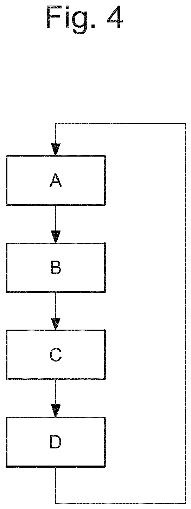

En référence à la figure 4, on comprend que le procédé de mise en rotation de la roue 61 au moyen du dispositif de rotation 100 décrit précédemment, comporte les étapes suivantes :
- étape A : au moyen de l'actionneur piézoélectrique 30, déplacer axialement l'élément passif 20 dans le premier sens de déplacement,
- étape B : au moyen de l'organe de transmission 71 poussant sur une dent 610 de la roue 61, faire tourner la roue 61 d'une dent selon le premier sens de rotation R1,
- étape D : au moyen de l'actionneur piézoélectrique 30, déplacer axialement l'élément passif 20 dans le deuxième sens de déplacement T2, le sautoir étant maintenu dans la position abaissée par les moyens de rappel 91 (étape C),
- répéter les étapes A, B, C, D autant de fois que nécessaire.

Dans le mode de réalisation illustré à la figure 3, la roue 62 est à denture classique : elle est conçue pour tourner dans le premier sens de rotation R1 aussi bien que dans le deuxième sens de rotation R2. Une rotation dans le premier sens de rotation R1 est possible par l'intermédiaire de l'organe de transmission 71 lorsque l'élément passif 20 est translaté dans le premier sens de déplacement T1, et une rotation dans le deuxième sens de rotation R2 est possible par l'intermédiaire de l'organe de transmission 71 lorsque l'élément passif 20 est translaté dans le deuxième sens de déplacement T2.

Dans le mode de réalisation, le dispositif de rotation 100 comporte des moyens d'actionnement 92 se présentant sous la forme d'un deuxième actionneur piézoélectrique linéaire (mais qui pourrait prendre d'autres formes, l'important étant qu'il s'agisse d'un élément actif, contrairement à l'exemple de la Fig. 2) apte à commander la position du sautoir 82. Si l'on souhaite faire tourner la roue 62 dans le premier sens de rotation R1, l'organe de transmission 72 doit être déplacé dans le premier sens de déplacement T1 par l'intermédiaire de l'élément passif 20, de sorte à faire tourner la roue 62 d'une dent dans le premier sens de rotation R1. En parallèle, le sautoir 82 doit être en position soulevée, c'est-à-dire qu'il ne doit pas être en contact avec la roue 62 pour ne pas entraver sa rotation. Puis, le sautoir 82 doit être amené en position abaissée, de sorte à bloquer la roue 61, et l'organe de transmission 72 doit être déplacé dans le deuxième sens de déplacement T2 par l'intermédiaire de l'élément passif 20, de sorte à être réarmé. En effectuant une pluralité d'allers et retours de l'élément passif 20, il est possible de faire tourner la roue dans le premier sens de rotation R1 d'une pluralité de dents.

Au contraire, si l'on souhaite faire tourner la roue 61 dans le deuxième de rotation R2, l'organe de transmission 72 doit être déplacé dans le deuxième sens de déplacement T2 par l'intermédiaire de l'élément passif 20, de sorte à faire tourner la roue 62 d'une dent dans le deuxième sens de rotation R2. En parallèle, le sautoir 82 doit être en position soulevée, c'est-à-dire qu'il ne doit pas être en contact avec la roue 62 pour ne pas entraver sa rotation. Puis, le sautoir 82 doit être amené en position abaissée, de sorte à bloquer la roue 62, et l'organe de transmission 72 doit être déplacé dans le premier sens de déplacement T1 par l'intermédiaire de l'élément passif 20, de sorte à être réarmé. En effectuant une pluralité d'allers et retours de l'élément passif 20, il est possible de faire tourner la roue dans le deuxième sens de rotation R2 d'une pluralité de dents.

On comprend que le procédé de mise en rotation de la roue 62 au moyen du dispositif de rotation 101 décrit précédemment, comporte les étapes suivantes :
- étape A : au moyen de l'actionneur piézoélectrique 30, déplacer axialement l'élément passif 20 dans un sens de déplacement,
- étape B : au moyen de l'organe de transmission 72 poussant sur une dent 620 de la roue 62, faire tourner la roue 62 d'une dent selon un sens de rotation, le sautoir 82 étant dans la position soulevée,
- étape C : placer le sautoir 82 dans la position abaissée au moyen des moyens d'actionnement 92,
- étape D : au moyen de l'actionneur piézoélectrique 30, déplacer axialement l'élément passif 20 dans un sens de déplacement opposé à celui de l'étape A, le sautoir étant maintenu dans la position abaissée,
- répéter les étapes A, B, C, D autant de fois que nécessaire.

On note que dans l'exemple de la Fig. 2 comme dans le mode de réalisation de la Fig. 3, le réarmement de l'élément passif 20 est gêné par une dent de la roue 61, 62: lors du réarmement, l'extrémité de l'élément passif 20 portant l'organe de transmission 71, 72 se soulève donc, mais est ramené dans son inclinaison initiale par les moyens de guidage dès que la dent est passée.

Le dispositif de rotation 100, 101 selon l'invention peut tout à fait être intégré à une pièce d'horlogerie de type montre-bracelet, notamment une pièce d'horlogerie comprenant une aiguille 40 coaxiale avec et solidaire en rotation de la roue 61, 62. Toutefois, le dispositif de rotation selon l'invention pourrait être utilisé pour entrainer en rotation non pas une aiguille, mais un disque (par exemple un disque des quantièmes ou un disque de phase de lune), une roue ou encore un anneau.

On comprendra que diverses modifications et/ou améliorations et/ou combinaisons évidentes pour l'homme du métier peuvent être apportées aux différentes formes d'exécution de l'invention exposée ci-dessus sans sortir du cadre de l'invention définie par les revendications annexées.

## Revendications

1. Dispositif de rotation (101) d'une roue dentée (62), comprenant :
- un moteur piézoélectrique linéaire comprenant :
• un élément passif (20) de forme allongée,
• un actionneur piézoélectrique (30) apte à déplacer axialement l'élément passif (20) de manière bidirectionnelle,
- un organe de transmission (72) fixé à l'élément passif (20), adapté pour être en prise avec une denture (620) de la roue (62) de sorte à faire tourner la roue (62) d'une dent selon un premier sens de rotation (R1) lorsque l'élément passif (20) est déplacé axialement selon un premier sens de déplacement (T1),
- un sautoir (82) mobile entre deux positions extrémales dont une position abaissée dans laquelle il bloque une rotation de la roue dans un deuxième sens de rotation (R2) opposé au premier sens de rotation (R1),
**caractérisé en ce que**
- l'organe de transmission (72) est adapté pour être en prise avec la denture de la roue (62) de sorte à faire tourner la roue (62) d'une dent dans le deuxième sens de rotation (R2) lorsque l'élément passif (20) est déplacé axialement selon un deuxième sens de déplacement (T2) opposé au premier sens de déplacement (T1), et
- le sautoir (82), dans sa position abaissée, est adapté à bloquer une rotation de la roue dans le premier sens de rotation (R1).

2. Dispositif de rotation (101) selon la revendication précédente, comprenant des moyens d'actionnement (92) permettant de basculer le sautoir (82) d'une position extrémale à l'autre.

3. Dispositif de rotation (101) selon la revendication précédente, dans lequel les moyens d'actionnement (92) comprenant un deuxième actionneur piézoélectrique linéaire permettant d'approcher et d'éloigner le sautoir (82) de la roue (62).

4. Dispositif de rotation (101) selon l'une des revendications précédentes, dans lequel l'actionneur piézoélectrique (30) comporte un résonateur comprenant une paire de bras (31, 32) connectés à l'une de leurs extrémités au niveau d'une zone de connexion (33), les deux autres extrémités (310, 320) étant dites libres, l'élément passif (20) passant entre les extrémités libres (310, 320) desdits bras (31, 32) de sorte à être déplacé axialement par friction des extrémités libres (310, 320) sur sa surface.

5. Dispositif de rotation (101) selon l'une des revendications précédentes, comprenant des moyens de guidage (50) axial de l'élément passif (20) tendant à ramener l'élément passif (20) dans sa position initiale lorsque l'élément passif (20) en est dévié sous l'effet d'un déplacement axial de l'élément passif (20) combiné à un blocage en rotation de la roue.

6. Pièce d'horlogerie comportant une roue (62) et un dispositif de rotation (101) selon l'une des revendications précédentes.

7. Pièce d'horlogerie selon la revendication précédente, comportant une aiguille (40) solidaire en rotation de la roue (62).

## Patentansprüche

1. Drehvorrichtung (101) eines Zahnrads (62), umfassend:
- einen linearen piezoelektrischen Motor, der Folgendes umfasst:
• ein passives Element (20) mit länglicher Form,
• einen piezoelektrischen Aktuator (30), der in der Lage ist, das passive Element (20) axial in zwei Richtungen zu bewegen,
- ein an dem passiven Element (20) befestigtes Übertragungselement (72), das mit einer Verzahnung (620) des Rades (62) so in Eingriff gebracht werden kann, dass das Rad (62) um einen Zahn in einer ersten Drehrichtung (R1) gedreht wird, wenn das passive Element (20) axial in einer ersten Bewegungsrichtung (T1) bewegt wird,
- eine Brücke (82), die zwischen zwei Endpositionen beweglich ist, einschließlich einer abgesenkten Position, in der sie eine Drehung des Rades in einer zweiten Drehrichtung (R2) entgegengesetzt zur ersten Drehrichtung (R1) blockiert, **dadurch gekennzeichnet, dass**
- das Übertragungselement (72) so ausgelegt ist, dass es mit der Verzahnung des Rades (62) in Eingriff steht, um das Rad (62) um einen Zahn in der zweiten Drehrichtung (R2) zu drehen, wenn das passive Element (20) axial in einer zweiten Bewegungsrichtung (T2) entgegengesetzt zur ersten Bewegungsrichtung (T1) bewegt wird, und
- die Brücke (82) in ihrer abgesenkten Position eine Drehung des Rades in der ersten Drehrichtung (R1) blockiert.

2. Drehvorrichtung (101) nach dem vorhergehenden Anspruch, mit Betätigungsmitteln (92), die es ermöglichen, die Brücke (82) von einer Endstellung in die andere zu schalten.

3. Drehvorrichtung (101) nach dem vorhergehenden Anspruch, wobei die Betätigungsmittel (92) einen zweiten linearen piezoelektrischen Aktuator umfassen, der es ermöglicht, die Brücke (82) zum Rad (62) hin und von ihm weg zu bewegen.

4. Drehvorrichtung (101) nach einem der vorhergehenden Ansprüche, **dadurch gekennzeichnet, dass** der piezoelektrische Aktuator (30) einen Resonator umfasst, der ein Paar Arme (31, 32) aufweist, die an einem ihrer Enden in einer Verbindungszone (33) verbunden sind, wobei die beiden anderen Enden (310, 320) frei sind und das passive Element (20) zwischen den freien Enden (310, 320) der genannten Arme (31, 32) so verläuft, dass es durch Reibung der freien Enden (310, 320) an seiner Oberfläche axial verschoben wird.

5. Drehvorrichtung (101) nach einem der vorhergehenden Ansprüche, mit Mitteln (50) zur axialen Führung des passiven Elements (20), die dazu neigen, das passive Element (20) in seine Ausgangsposition zurückzubringen, wenn das passive Element (20) unter der Wirkung einer axialen Bewegung des passiven Elements (20) in Kombination mit einer Blockierung des Rads in der Drehung von dieser Position abweicht.

6. Uhrwerk mit einem Rad (62) und einer Drehvorrichtung (101) nach einem der vorhergehenden Ansprüche.

7. Uhrwerk nach dem vorhergehenden Anspruch, mit einem Zeiger (40), der mit dem Rad (62) drehfest verbunden ist.

## Claims

1. Device (101) for rotating a toothed wheel (62), comprising:
- a linear piezoelectric motor comprising:
• a passive element (20) having an elongated shape,
• a piezoelectric actuator (30) capable of axially moving the passive element (20) in a bidirectional manner,
- a transmission member (72) fastened to the passive element (20), adapted to be meshing with a toothing (620) of the wheel (62) in such a way as to rotate the wheel (62) by one tooth in a first direction of rotation (R1) when the passive element (20) is moved axially in a first direction of movement (T1),
- a jumper (82) mobile between two end positions, including a lowered position in which it blocks a rotation of the wheel in a second direction of rotation (R2) opposite to the first direction of rotation (R1), **characterized in that**
- the transmission member (72) is adapted to be meshing with the toothing of the wheel (62) in such a way as to rotate the wheel (62) by one tooth in the second direction of rotation (R2) when the passive element (20) is moved axially in a second direction of movement (T2) opposite to the first direction of movement (T1), and
- the jumper (82), in its lowered position, blocks a rotation of the wheel in the first direction of rotation (R1).

2. Rotation device (101) according to the previous claim, comprising actuation means (92) allowing to switch the jumper (82) from one end position to the other.

3. Rotation device (101) according to the previous claim, wherein the actuation means (92) comprise a second linear piezoelectric actuator allowing to move the jumper (82) towards and away from the wheel (62).

4. Rotation device (101) according to one of the previous claims, wherein the piezoelectric actuator (30) comprises a resonator comprising a pair of arms (31, 32) connected at one of their ends at a connection zone (33), the two other ends (310, 320) being called free, the passive element (20) passing between the free ends (310, 320) of said arms (31, 32) in such a way as to be moved axially by friction of the free ends (310, 320) on its surface.

5. Rotation device (101) according to one of the previous claims, comprising means (50) for axial guiding of the passive element (20) tending to return the passive element (20) to its initial position when the passive element (20) is deviated therefrom under the effect of an axial movement of the passive element (20) combined with a blocking of the wheel in rotation.

6. Piece of clockwork comprising a wheel (62) and a rotation device (101) according to one of the previous claims.

7. Piece of clockwork according to the previous claim, comprising a hand (40) integral in rotation with the wheel (62).
